(19) Europäisches Patentamt
European Patent Office
Office européen des brevets

(11) **EP 3 772 654 A1**

(12) **EUROPEAN PATENT APPLICATION**

(43) Date of publication:
**10.02.2021 Bulletin 2021/06**

(51) Int Cl.:
**G01R 15/24** *(2006.01)*

(21) Application number: **19190749.2**

(22) Date of filing: **08.08.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ABB Schweiz AG**
**5400 Baden (CH)**

(72) Inventor: **BOHNERT, Klaus**
**5452 Oberrohrdorf (CH)**

(74) Representative: **Vossius & Partner**
**Patentanwälte Rechtsanwälte mbB**
**Siebertstrasse 3**
**81675 München (DE)**

(54) **OPTICAL VOLTAGE SENSING DEVICE**

(57) The invention relates to a voltage sensing device comprising an integrated-optic waveguide beam splitter, having a splitter plane, a first polarizing element, coupled to the integrated-optic waveguide beam splitter and having a first polarization direction with respect to a normal of the splitter plane, a second polarizing element, coupled to the integrated-optic waveguide beam splitter and having the first polarization direction with respect to the normal of the splitter plane, and a third polarizing element, coupled to the integrated-optic waveguide beam splitter and having a second polarization direction orthogonal to the first polarization direction, a birefringent optical element, having a principal axis at 45° to the first polarization direction, and at least one electro-optic sensing element, having an electro-optic axis in a range at 45° to the first polarization direction, wherein a light signal passes the first polarizing element, the birefringent optical element, and the at least one electro-optic sensing element; wherein the birefringent optical element is configured to introduce a phase bias in a range of $(2n-1) \times 45°$ or $(2n-1) \times 90°$ between two orthogonal polarization components of the light signal, where n is a positive integer; wherein the at least one electro-optic sensing element is configured to introduce a differential electro-optic phase shift between two orthogonal polarization components of the light signal in response to an electric field generated by a voltage; wherein the integrated-optic waveguide beam splitter is configured to split the light signal into a first split light signal and a second split light signal, to transmit the first split light signal to the second polarizing element and to transmit the second split light signal to the third polarizing element.

FIG. 1

**Description**

FIELD OF THE INVENTION

The invention relates to an optical voltage sensing device for an electric power transmission system.

BACKGROUND OF THE INVENTION

Optical electric field and voltage sensors commonly make use of an electro-optic effect (Pockels effect) in crystalline materials. Examples of electro-optic transducer materials are lithium niobate ($LiNbO_3$), lithium tantalate ($LiTaO_3$), bismuth germanium oxide, BGO ($Bi_4Ge_3O_{12}$), or compound semiconductors like cadmium telluride CdTe. The transducers may be designed as bulk crystals, optical waveguide devices, or thin wafer platelets.

High voltage sensors for the electric power transmission systems often employ bulk crystals. The electric field introduces a differential electro-optic phase shift between two orthogonal polarization states of the light. A combination of a waveplate and a polarizer converts the phase shift into a variation of light power in proportion to the sine of the field. Drawbacks of this sensor type are bulkiness and the need for labor intense alignment of its optical components (collimators, beam splitter, wave plate, polarizers, and optical fiber pigtails).

In electro-optic waveguide devices the waveguides typically form a Mach Zehnder interferometer, e.g. in a lithium niobate substrate. The voltage is applied via pairs of strip electrodes parallel to the waveguides. The electric field causes a differential phase shift between the two interferometer branches and hence a corresponding change in the optical power output of the interferometer. Sensors of this type equipped with antennas have been employed for mapping of high frequency fields. A challenge is to maintain a defined and stable phase bias between the two interferometer branches.

Some electro-optic probes for high frequency field mapping, e. g, fields on circuit boards and antennas, employ a thin electro-optic crystal wafer that forms a Fabry Perot cavity on the tip of an optical fiber. A change of the electric field strength changes the power reflected from the Fabry Perot cavity back into the fiber. The sensors require relatively sophisticated interrogation techniques that involve for example a temperature stabilized DFB laser and an electro-optic modulator.

Other relevant prior art includes a fiber-optic current sensor that employs an integrated-optic polarization splitter. The splitter converts the differential magnetooptic phase shift of two orthogonal polarization states into two anti-phase detector signals proportional to the sine of the applied current.

DESCRIPTION OF THE INVENTION

The present invention relates to a voltage sensing device comprising:

an integrated-optic waveguide beam splitter, having a splitter plane,

a first polarizing element, coupled to the integrated-optic waveguide beam splitter and having a first polarization direction with respect to a normal of the splitter plane,

a second polarizing element, coupled to the integrated-optic waveguide beam splitter and having the first polarization direction with respect to the normal of the splitter plane, and

a third polarizing element, coupled to the integrated-optic waveguide beam splitter and having a second polarization direction orthogonal to the first polarization direction,

a birefringent optical element, having a principal axis at 45° ($\pm$15°) to the first polarization direction, and

at least one electro-optic sensing element, having an electro-optic axis at 45° ($\pm$15°) to the first polarization direction,

wherein the voltage sensing device is configured to let a light signal pass the first polarizing element, the birefringent sensing element, and the at least one electro-optic sensing element;

wherein the birefringent optical element is configured to introduce a phase bias in a range of (2n -1) $\times$ 90° ($\pm$15°) between two orthogonal polarization components of the light signal, where n is a positive integer;

wherein the at least one electro-optic sensing element is configured to introduce a differential electro-optic phase shift between two orthogonal polarization components of the light signal in response to an electric field generated by a voltage;

wherein the integrated-optic waveguide beam splitter is configured to split the light signal into a first split light signal and a second split light signal, to transmit the first split light signal to the second polarizing element and to transmit the second split light signal to the third polarizing element.

It is clear for the skilled person that (x°±y°) denotes a range, i.e. a range from x°-y° to x+y°; e.g., in the case of x=90° and y=15° it denotes a range from 75° to 105°.

The present invention also relates to a voltage sensing device, comprising:

an integrated-optic waveguide beam splitter, having a splitter plane,

a first polarizing element, coupled to the integrated-optic waveguide beam splitter and having a first polarization direction with respect to a normal of the splitter plane,

a second polarizing element, coupled to the integrated-optic waveguide beam splitter and having the first polarization direction with respect to the normal of the splitter plane, and

a third polarizing element, coupled to the integrated-optic waveguide beam splitter and having a second polarization direction orthogonal to the first polarization direction,

a birefringent optical element, having a principal axis at 45° (±15°) to the first polarization direction, and

at least one electro-optic sensing element, having an electro-optic axis at 45° (±15°) to the first polarization direction,

wherein the voltage sensing device is configured to let a light signal pass the first polarizing element, the birefringent sensing element, and the at least one electro-optic sensing element;

wherein the birefringent optical element is configured to introduce a phase bias in a range of (2n -1) × 45° (±15°) between two orthogonal polarization components of the light signal, where n is a positive integer;

wherein the at least one electro-optic sensing element is configured to introduce a differential electro-optic phase shift between two orthogonal polarization components of the light signal in response to an electric field generated by a voltage;

wherein the integrated-optic waveguide beam splitter is configured to split the light signal into a first split light signal and a second split light signal, to transmit the first split light signal to the second polarizing element and to transmit the second split light signal to the third polarizing element.

As mentioned above, (x°±y°) denotes a range, i.e. a range from x°-y° to x+y°; e.g., in the case of x=90° and y=15° it denotes a range from 75° to 105°.

The following features of embodiments can be used in conjunction with either one of the voltage sensing devices defined above.

Preferably, the electro-optic sensing element (EOS) is in physical contact with the integrated-optic waveguide beam splitter (IOW), preferably via a layer of adhesive or an air gap.

Preferably, the birefringent optical element and the at least one electro-optic sensing element are integrally formed as a single element.

Preferably, the first polarization direction is 0° with respect to the normal of the splitter plane.

Preferably, the first polarization direction is 45° with respect to the normal of the splitter plane.

Preferably, the voltage sensing device further comprises a first electrode configured at a first side of the at least one electro-optic sensing element, and a second electrode configured at a second side of the at least one electro-optic sensing element opposite to the first side of the at least one electro-optic sensing element, wherein at least one of the first electrode and second electrode is ohmically (electrically/directly) coupled to an electric field generating electrode.

Preferably, the voltage sensing device further comprises a dielectric layer, wherein the at least one electro-optic sensing element is configured in the dielectric layer, a first conductive layer, coupled to the dielectric layer at a first side of the dielectric layer and ohmically coupled to the first electrode, and a second conductive layer, coupled to the dielectric layer at a second side of the dielectric layer opposite to the first side of the dielectric layer and ohmically coupled to the second electrode.

Preferably, the first conductive layer and the second conductive layer are electrodes.

Preferably, the at least one electro-optic sensing element, the first electrode and the second electrode form a first capacitor and the dielectric layer, the first conductive layer and the second conductive layer form a second capacitor parallel to the first capacitor.

Preferably, a dielectric constant of the dielectric layer is smaller than a dielectric constant of the at least one electro-optic sensing element.

Preferably, a surface area covered by the first conductive layer and the second conductive layer is greater than a surface area covered by the first electrode and the second electrode.

Preferably, a thickness of the dielectric layer is equal to or greater than a thickness of the at least one electro-optic sensing element.

Preferably, the at least one electro-optic sensing element comprises at least one electro-optic crystal.

Preferably, the at least one electro-optic crystal consists of one of $Bi_4Ge_3O_{12}$, (BGO), $Bi_4Si_3O_{12}$(BSO), crystalline quartz, $LiTaO_3$, and $LiNbO_3$.

Preferably, the at least one electro-optic sensing element comprises a first electro-optic sensing element, configured to introduce a differential electro-optic phase shift between two orthogonal polarization components of the light signal in response to the electric field generated by the voltage, and a second electro-optic sensing element, configured to introduce a differential electro-optic phase shift between two orthogonal polarization components of the first split light signal and the second split light signal in response to the electric field generated by the voltage.

Preferably, the birefringent optical element is provided in a recess of the integrated-optic waveguide beam splitter.

Preferably, the at least one electro-optic sensing element is configured in a recess of the integrated-optic waveguide beam splitter.

Preferably, the first polarizing element, the second polarizing element and the third polarizing element are coupled to a first side of the integrated-optic waveguide beam splitter and the voltage sensing device further comprises a reflector configured to make the light signal return to the integrated-optic waveguide beam splitter.

Preferably, the first polarizing element and the second polarizing element are implemented by a first polarizer and the third polarizing element is implemented by a second polarizer.

Preferably, the birefringent optical element, the at least one electric-optical sensing element and the reflector are coupled to a second side of the integrated-optic waveguide beam splitter opposite to the first side of the integrated-optic waveguide beam splitter.

Preferably, the birefringent optical element and the at least one electro-optic sensing element are coupled to the first side of the integrated-optic waveguide beam splitter, the first polarizing element, the second polarizing element and the third polarizing element are coupled to the at least one electro-optic sensing element, and the reflector is coupled to a second side opposite to the first side of the integrated-optic waveguide beam splitter.

Preferably, the reflector is coupled to the second side of the integrated-optic waveguide beam splitter via an optical fiber.

Preferably, the birefringent optical element and the at least one electro-optic element are coupled to the first side of the integrated-optic waveguide beam splitter, the first polarizing element is coupled to the at least one electro-optic element, and the second polarizing element and the third polarizing element are coupled to a second side of the integrated-optic waveguide beam splitter opposite to the first side of the integrated-optic waveguide beam splitter.

Preferably, the at least one electro-optic sensing element is ohmically coupled to an external electrode and introduces the differential electro-optic phase shift in response to a voltage, i.e. a potential difference of the external electrode with respect at least one other electrode

Preferably, the principal axis of the birefrigent optical element is at 45° ($\pm$10°) to the first polarization direction.

More preferably, the principal axis of the birefringent optical element is at 45° ($\pm$5°) to the first polarization direction.

More preferably, the principal axis of the birefringent optical element is at 45° ($\pm$1 °) to the first polarization direction.

Preferably, the phase bias introduced by the birefringent optical element is in a range of (2n -1) $\times$ 45° ($\pm$10°), where n is a positive integer.

More preferably, the phase bias introduced by the birefringent optical element is in a range of (2n -1) $\times$ 45° ($\pm$5°), where n is a positive integer.

More preferably, the phase bias introduced by the birefringent optical element is (2n -1) $\times$ 45° ($\pm$1°).

More preferably, the phase bias introduced by the birefringent optical element is (2n-1) $\times$ 45°.

Preferably, the phase bias introduced by the birefringent optical element is in a range of (2n -1) $\times$ 90° ($\pm$10°), where n is a positive integer.

More preferably, the phase bias introduced by the birefringent optical element is in a range of (2n -1) $\times$90°

($\pm 5°$), where n is a positive integer.

More preferably, the phase bias introduced by the birefringent optical element is $(2n-1) \times 90°$ ($\pm 1°$).

More preferably, the phase bias introduced by the birefringent optical element is $(2n-1) \times 90°$.

Preferably, the first electro-optic axis of the at least one electro-optic sensing element is in a range of at 45° ($\pm 10°$) to the first polarization direction.

More preferably, the first electro-optic axis of the at least one electro-optic sensing element is at 45° ($\pm 5°$) to the first polarization direction.

More preferably, the first electro-optic axis of the at least one electro-optic sensing element is at 45°($\pm 1°$) to the first polarization direction.

More preferably, the first electro-optic axis of the at least one electro-optic sensing element is at 45° to the first polarization direction.

The present invention also relates to a voltage sensing device, comprising:

an integrated-optic waveguide beam splitter (IOW), having a splitter plane,

a first polarizing element, coupled to the integrated-optic waveguide beam splitter and having a first polarization direction with respect to a normal of the splitter plane,

a second polarizing element, coupled to the integrated-optic waveguide beam splitter and having the first polarization direction with respect to the normal of the splitter plane, and

a third polarizing element, coupled to the integrated-optic waveguide beam splitter and having a second polarization direction,

a birefringent optical element, having a principal axis at 45° ($\pm 15°$) to the first polarization direction, and

an electro-optical sensing element, having an electro-optical axis at 45° ($\pm 15°$) to the first polarization direction,

wherein the light signal passing the first polarizing element and the electro-optic sensing element,

wherein the electro-optical sensing element is configured to introduce a differential electro-optic phase shift between two orthogonal polarization components of the light signal parallel to the electro-optic axes in response to an electric field generated by a voltage,

wherein the integrated-optic waveguide beam splitter is configured to split the light signal into a first split light signal and a second split light signal, to transmit the first split light signal to the second polarizing element and to transmit the second split light signal to the third polarizing element,

wherein the birefringent optical element is configured to introduce a $(2n-1) \times 90°$ ($\pm 15°$) phase bias between two orthogonal polarization components of at least one of the first split light signal and the second split light signal, where n is a positive integer.

Preferably, the first polarization direction is 0° with respect to the normal of the splitter plane.

Preferably, the first polarization direction is 45° with respect to the normal of the splitter plane.

Preferably, the electro-optical sensing element comprises a first electrode configured at a first side of the electro-optic sensing element, and a second electrode configured at a second side of the electro-optic sensing element opposite to the first side of the electro-optic sensing element, wherein at least one of the first electrode and second electrode is ohmically coupled to an electric field generating electrode.

Preferably, the voltage sensing device further comprises a dielectric layer, wherein the electro-optic sensing element is configured in the dielectric layer , a first conductive layer, coupled to the dielectric layer at a first side of the dielectric layer and ohmically coupled to the first electrode, and a second conductive layer, coupled to the dielectric layer at a second side of the dielectric layer opposite to the first side of the dielectric layer and ohmically coupled to the second electrode.

Preferably, the first conductive layer and the second conductive layer are electrodes.

Preferably, the at least one electro-optic sensing element, the first electrode and the second electrode form a first capacitor and the dielectric layer, the first conductive layer and the second conductive layer form a second capacitor parallel to the first capacitor.

Preferably, a dielectric constant of the dielectric layer is smaller than a dielectric constant of the electro-optic sensing element.

Preferably, a surface area covered by the first conductive layer and the second conductive layer is greater than a surface area covered by the first electrode and the second electrode.

Preferably, a thickness of the dielectric layer is equal to or greater than a thickness of electro-optic sensing element.

Preferably, the electro-optical crystal consists of one of $Bi_4Ge_3O_{12}$(BGO), $Bi_4Si_3O_{12}$ (BSO), quartz, $LiTaO_3$, and $LiNbO_3$.

Preferably, the electro-optical sensing element is coupled to a first side of the integrated-optic waveguide beam splitter, the first polarizing element is coupled to the electro-optical sensing element, wherein the second polarizing element and the third polarizing element are coupled to a second side of the integrated-optic waveguide beam splitter opposite to the first side of the integrated-optic waveguide beam splitter, wherein the first polarization direction and the second polarization direction are the same and the second polarizing element.

Preferably, the voltage sensing device further comprises a first collimating graded index lens, coupled between the electro-optical sensing element and the integrated-optic waveguide beam splitter and configured to couple the light signal into the integrated-optic waveguide beam splitter, and a second collimating graded index lens, coupled to the first polarizing element and configured to collimated the light signal before the light signal enters the first polarizing element.

Preferably, the first polarizing element, the second polarizing element and the third polarizing element are coupled to a first side of the integrated-optic waveguide beam splitter, the electro-optical sensing element is coupled to a second side of the integrated-optic waveguide beam splitter opposite to the first side of the integrated-optic waveguide beam splitter via a polarization-maintaining optical fiber (PMF) with a principal axis at 0° with respect to the normal of the splitter plane.

Preferably, the voltage sensing device further comprises a collimating graded index lens, coupled to the optical fiber, a faraday rotator, coupled between the collimating graded index lens and the electro-optical sensing element and configured to rotate the light signal by 45° per pass, and a reflector, coupled to the electro-optical sensing element configured to reflect the light signal to the electro-optical crystal.

Preferably, the first polarizing element and the second polarizing element are implemented by a polarizer and the third polarizing element is implemented by another polarizer.

Preferably, the birefringent optical element is provided in a recess of the integrated-optic waveguide beam splitter.

Preferably, the principal axis of the birefringent optical element is at 45° (±10°) to the first polarization direction.

Preferably, the principal axis of the birefringent optical element isat 45° (±5°) to the first polarization direction.

Preferably, the principal axis of the birefringent optical element is at 45° (±1°) to the first polarization direction.

Preferably, the principal axis of the birefringent optical element is at 45° to the first polarization direction.

Preferably, the phase bias introduced by the birefringent optical element is in a range of (2n -1) × 90° (±10°), where n is a positive integer.

Preferably, the phase bias introduced by the birefringent optical element is in a range of (2n -1) × 90° (±5°), where n is a positive integer.

Preferably, the phase bias introduced by the birefringent optical element is (2n - 1) × 90° (±1°).

Preferably, the electro-optic axis of the at least one electro-optic sensing element is at 45° (±10°), to the first polarization direction.

Preferably, the electro-optic axis of the at least one electro-optic sensing element is at 45° (±5°), to the first polarization direction.

Preferably, the electro-optic axis of the at least one electro-optic sensing element is at 45° (±1°) to the first polarization direction.

Preferably, the electro-optic axis of the at least one electro-optic sensing element is at 45° to the first polarization direction.

The present invention also relates to a voltage sensing device, comprising:

an integrated-optic waveguide beam splitter, having a splitter plane,

a first polarizing element, coupled to the integrated-optic waveguide beam splitter at a first side of the integrated-optic waveguide beam splitter and having a first polarization direction with respect to a normal of the splitter plane,

a second polarizing element, coupled to the integrated-optic waveguide beam splitter at the first side of the integrated-optic waveguide beam splitter and having the first polarization direction with respect to the normal of the splitter plane, and

a third polarizing element, coupled to the integrated-optic waveguide beam splitter at the first side of the integrated-optic waveguide beam splitter and having a second polarization direction orthogonal to the first polarization direction,

a birefringent optical element, having a principal axis at 45° ($\pm$15°), to the first polarization direction,

a Faraday rotator, configured to rotate a light signal by a rotation angle in a range 45° ($\pm$15°), for each pass and coupled to a second side of the integrated-optic waveguide beam splitter opposite to the first side of the integrated-optic waveguide beam splitter via a polarization-maintaining optical fiber with a principal axis at 45° with respect to the first polarization direction, and

a plurality of piezo-electric transducer elements, attached to a first sensing section of polarization maintaining fiber and a second sensing section of polarization maintaining fiber,

wherein the piezo-electric transducer elements are configured so that the piezo-electric strains of the piezo-electric transducer elements attached to the first sensing section of polarization maintaining fiber are opposite in sign to the piezo-electric strains of the piezo-electric transducer elements attached to the second sensing section of polarization maintaining fiber;

wherein the first sensing section of polarization maintaining fiber is coupled to the Faraday rotator and the second sensing section of polarization maintaining fiber,

wherein a slow axis of the first sensing section of polarization maintaining fiber is orthogonal to a slow axis of the second sensing section of polarization maintaining fiber;

wherein the light signal passes the first polarizing element, the birefringent optical element, the integrated-optic waveguide beam splitter, the Faraday rotator and first and second sensing section of polarization-maintaining fiber,

wherein the plurality of piezo-optical transducer elements are configured to introduce a differential piezo-optic phase shift between the orthogonal polarization components of the light signal in response to an electric field generated by a voltage,

wherein the integrated-optic waveguide beam splitter is configured to split the light signal into a first split light signal and a second split light signal, to transmit the first split light signal to the second polarizing element and to transmit the second split light signal to the third polarizing element,

wherein the birefringent optical element is configured to introduce a phase bias in a range of (2n -1) $\times$ 45° ($\pm$15°) or (2n -1) $\times$ 90° ($\pm$15°) between two orthogonal polarization components of at least one of the light signal , the first split light signal and the second split light signal, where n is a positive integer.

Preferably, a reflector configured to reflect the light signal to the plurality of piezo-electric transducer elements.
Preferably, the first sensing section of the polarization maintaining fiber and the second sensing section of the polarization maintaining fiber form a closed loop.
Preferably, the first polarization direction is 0° with respect to the normal of the splitter plane.
Preferably, the first polarization direction is 45° with respect to the normal of the splitter plane.
Preferably, the birefringent optical element is provided in a recess of the integrated-optic waveguide beam splitter.
Preferably, the first polarization element and the second polarization element are implemented by a polarizer and the third polarization element is implemented by another polarizer.
Preferably, the principal axis of the birefringent optical element is at 45° ($\pm$10°), to the first polarization direction.
Preferably, the principal axis of the birefringent optical element is 45° ($\pm$5°), to the first polarization direction.
Preferably, the principal axis of the birefringent optical element is at 45° ($\pm$1°), to the first polarization direction.
Preferably, the principal axis of the birefringent optical element is at 45°, to the first polarization direction.
Preferably, the rotation angle of the Faraday rotator is 45° ($\pm$10°),
**[0090]** Preferably, the rotation angle of the Faraday rotator is 45° ($\pm$5°),
**[0091]** Preferably, the rotation angle of the Faraday rotator is 45($\pm$1°).
Preferably, the rotation angle of the Faraday rotator is 45($\pm$1°).
Preferably, the phase bias introduced by the birefringent optical element is in a range of (2n -1) $\times$ 90° ($\pm$10°), where n is a positive integer.
Preferably, the phase bias introduced by the birefringent optical element is in a range of (2n -1) $\times$ 90° ($\pm$5°),

where n is a positive integer.

Preferably, the phase bias introduced by the birefringent optical element is $(2n - 1) \times 90°$ ($\pm 1°$), where n is a positive integer.

Preferably, the phase bias introduced by the birefringent optical element is $(2n - 1) \times 90°$, where n is a positive integer.

BRIEF DESCRIPTION OF THE DRAWINGS

The subject matter of the invention will be explained in more detail in the following text with reference to preferred exemplary embodiments which are illustrated in the attached drawings, in which:

FIG. 1 relates a voltage sensing device according to an embodiment of the present disclosure.

FIG. 2 relates a voltage sensing device according to an embodiment of the present disclosure.

FIG. 3 relates a voltage sensing device according to an embodiment of the present disclosure.

FIG. 4 relates a voltage sensing device according to an embodiment of the present disclosure.

FIG. 5 relates a voltage sensing device according to an embodiment of the present disclosure.

FIG. 6 relates a voltage sensing device according to an embodiment of the present disclosure.

FIG. 7 relates a voltage sensing device according to an embodiment of the present disclosure.

FIG. 8 relates a voltage sensing device according to an embodiment of the present disclosure.

FIG. 9 relates to an arrangement of a voltage sensing device according to an embodiment of the present disclosure.

FIG. 10 relates to an arrangement of a voltage sensing device according to an embodiment of the present disclosure.

FIG. 11 relates to an arrangement of a voltage sensing device according to an embodiment of the present disclosure.

FIG. 12 relates a voltage sensing device according to an embodiment of the present disclosure.

FIG. 13 relates a voltage sensing device according to an embodiment of the present disclosure.

FIG. 14 relates a voltage sensing device according to an embodiment of the present disclosure.

FIG. 15 relates a voltage sensing device according to an embodiment of the present disclosure.

FIG. 16 relates an arrangement of a plurality of piezo-electric transducer elements according to an embodiment of the present disclosure.

FIG. 17 relates a voltage sensing device according to an embodiment of the present disclosure.

In principle, identical parts are provided with the same reference symbols in the figures.

DETAILED DESCRIPTION OF PREFERRED EMBODIMENTS

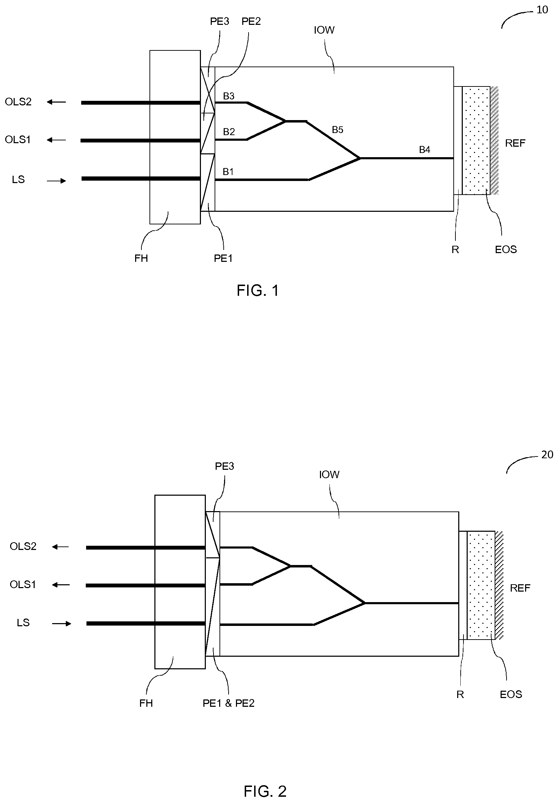

FIG. 1 relates to a voltage sensing device 10 according to an embodiment of the present disclosure. As shown in FIG. 1, the voltage sensing device 10 comprises a fiber holder FH, polarizing elements PE1, PE2, PE3, an integrated-optic waveguide beam splitter IOW, a birefringent optical element R, an electro-optic sensing element EOS and a reflector REF. In this embodiment, the polarizing elements PE1, PE2 and PE3 are coupled to a side of the integrated-optic waveguide beam splitter IOW and the birefringent optical element R, the electro-optic sensing element EOS and the reflector REF are coupled to an opposite side of the integrated-optic waveguide beam splitter IOW. In an embodiment, the electro-optic element EOS may comprise an electro-optic crystal consisting of one of $Bi_4Ge_3O_{12}$ (BGO), $Bi_4Si_3O_{12}$ (BSO), crystalline quartz (i.e., $SiO_2$), $LiTaO_3$, and $LiNbO_3$ and the reflector REF is a metallic reflector, such as a gold layer with a thin chromium under-layer for better adhesion, or a dielectric reflector.

In detail, the integrated-optic waveguide beam splitter IOW may be a 1 × 3 splitter (e.g. a planar light waveguide circuit (PLC) splitter). In an embodiment, the integrated-optic waveguide beam splitter IOW comprises a glass substrate with waveguides fabricated by electric-field-assisted ion exchange. The polarizing elements PE1, PE2, PE3 are coupled to the integrated-optic waveguide beam splitter IOW at a side where a light signal LS is input and the birefringent optical element R, the electro-optic sensing element EOS and the reflector REF are coupled to the opposite side of the integrated-optic waveguide beam splitter IOW. In this embodiment, the polarization direction of the polarizing elements PE1 and PE2 is 0° with respect to the normal of a splitter plane of the integrated-optic waveguide beam splitter IOW and the polarization direction of the polarizing element PE3 is 90° with respect to the normal of the splitter plane (i.e. orthogonal to the normal of the splitter plane). The birefringent optical element R may be a λ/8-wave retarder of order n and has a principal axis at 45° (±15°) with respect to the normal of the splitter plane, i.e., the element introduces a single pass differential phase retardation of (2n-1)×45° between orthogonal polarization components of the light signal parallel to the principal axes of the element; wherein n is a positive integer. In a preferable embodiment, a principal axis is at 45° (±10°) with respect to the normal of the splitter plane. In a more preferable embodiment, a principal axis is at 45° (±5°) with respect to the normal of the splitter plane. In a even more preferable embodiment, a principal axis is at 45°±1° with respect to the normal of the splitter plane. The electro-optic sensing element EOS is coupled to the birefringent optical element R, and the reflector REF is coupled to the electro-optic sensing element EOS. The electro-optic sensing element EOS has an electro-optic axis which is at 45° (±15°) with respect to the polarization direction of the polarizing element PE1 (i.e. the normal of the splitter plane). In a preferable embodiment, the electro-optic sensing element EOS has an electro-optic axis at at 45° (±10°) with respect to the polarization direction of the polarizing element PE1. In a more preferable embodiment, the electro-optic sensing element EOS has an electro-optic axis which is at 45° (±5°) with respect to the polarization direction of the polarizing element PE1. In an even more preferable embodiment, the electro-optic sensing element EOS an electro-optic axis at 45°±1° with respect to the polarization direction of the polarizing element PE1.

For sensing an electric field generated by a voltage, a light signal LS is input, via an optical fiber (e.g. a single mode optical fiber) fixed by the fiber holder FH, to the polarizing element PE1. The light signal LS may be depolarized light generated from a broadband light source (not shown in FIG. 1). For example, the broadband light source could be a super-luminescent light emitting diode (SLED), but is not limited thereto. After passing and being polarized by the polarizing element PE1, the light signal LS is transmitted through waveguides branches B1 and B4 of a source channel waveguide in the integrated-optic waveguide beam splitter IOW, passes the birefringent optical element R and the electro-optic sensing element EOS and is reflected by the reflector REF to the waveguides branch B4 of the integrated-optic waveguide beam splitter IOW. Since the light signal LS passes the birefringent optical element R twice, the birefringent optical element R introduces a phase bias of (2n-1)×90° between orthogonal polarization components of the light signal LS, wherein n is a positive integer (i.e. n = 1, 2, 3, ... etc). In a preferable embodiment, the phase bias introduced by the birefringent optical element R is in a rage of (2n-1)×90° (±10°), wherein n is a positive integer. In a more preferable embodiment, the phase bias introduced by the birefringent optical element R is in a rage of (2n-1)x90° (±5°), wherein n is a positive integer. In an even more preferable embodiment, the phase bias introduced by the birefringent optical element R is (2n-1)x90° (±1°). wherein n is a positive integer.

In the embodiment shown in FIG. 1, the longitudinal electric field, which is generated by the voltage V and applied to the electro-optic sensing element EOS, introduces a differential phase shift Δφ between orthogonal polarization components of the light signal LS parallel to the electro-optic axes of the electro-optic sensing element EOS when the light signal LS passes through the electro-optic sensing element EOS. The phase shift Δφ can be expressed as:

$$\Delta\phi = (2\pi/\lambda)\, n_o^3\, r\, V \qquad (1)$$

where, $\lambda$ is a wavelength of the light signal LS, $n_o$ is a refractive index of the electro-optic sensing element EOS, r is a relevant electro-optic coefficient, and V is the voltage.

Next, the light signal LS splits into waveguides branches B1 to B3. The split light signals of the waveguides branches B2 and B3 are transmitted to the polarizing elements PE2 and PE3 and become the output light signals OLS1 and OLS2 after passing the polarizing elements PE2 and PE3, respectively. Note that, the intensities of output light signals OLS1 and OLS2 are approximately the same at V = 0. That is, the splitting ratio for the junction of the waveguides branches B2, B3 is 1:1. In an example, a splitting ratio among the waveguides branches B1 to B3 is 1:1:1, which is achieved with a splitting ratio 1:2 for a junction of the waveguides braches B1 and B5. The output light signals OLS1 and OLS2 can be expressed as:

$$S_1 = (S_o/2)\,(1 + \sin \Delta\phi) \qquad\qquad (2)$$

$$S_2 = (S_o/2)\,(1 - \sin \Delta\phi) \qquad\qquad (3)$$

where S0 is a light intensity proportional to the light source power, S1 is a light intensity of the output light signal OLS1, and S2 is a light intensity of the output light signal OLS2. The difference between the output light signals OLS1 and OLS2 divided by the sum of the output light signals OLS1 and OLS2 gives an output S which his independent of the light intensity S0:

$$S = (S_1 - S_2) / (S_1 + S_2) \qquad\qquad (4)$$

$$S = \sin \Delta\phi \qquad\qquad (5)$$

In typical case in practices, $\Delta\phi \ll 1$:

$$S = \Delta\phi \qquad\qquad (6)$$

Based on equations (1) and (6), the phase shift $\Delta\phi$ is proportional to the voltage V. Thus, the voltage V can be determined based on the phase shift $\Delta\phi$ which can be derived from the output light signals OLS1 and OLS2. In an embodiment, the output light signals OLS1 and OLS2 may be output to a photo detecting module (not shown in FIG. 1) for detecting the light intensities and determining the phase shift $\Delta\phi$ based on equations (1) to (6). For example, the output light signals OLS1 and OLS2 are transmitted to photo detectors (not shown in FIG. 1), to generate related electric signals required by a processing unit (e.g. an integrated circuit) (not shown in FIG. 1) for determining the voltage V based on equations (1) to (6).

Note that the waveguides in the integrated-optic waveguide beam splitter IOW are ideally free of linear birefringence. In practice, however, the waveguides in the integrated-optic waveguide beam splitter IOW may exhibit finite birefringence with the principal axes parallel and orthogonal to the normal of the splitter plane of the integrated-optic waveguide beam splitter IOW. With the orientations of the polarizing elements PE1, PE2, PE3, the birefringent optical element R and the electro-optic sensing element EOS in the embodiment shown in FIG. 1, the birefringence generated by the waveguides in the integrated-optic waveguide beam splitter IOW has no effect on the output light signals OLS1 and OLS2.

In the embodiment shown in FIG. 1, the fibers transmitting the light signal LS and the output light signals OLS1 and OLS2 may be single mode fibers. In order to reduce polarization-dependent loss, the fibers may include Lyot-type fiber depolarizers. Alternatively, multimode fibers may be used for transmitting the output light signals OLS1 and OLS2. The polarizing elements PE1, PE2 and PE3 may be thin glass platelets containing oriented metal (e.g. silver particles) to polarize the light. The thickness of the thin glass platelets may be, e.g., 30 $\mu$m.

Due to the use of the integrated-optic waveguide beam splitter IOW which is a passive element, the voltage sensing device 10 is able to be part of the sensor head assembly. As a result, there is no need of polarization maintaining special fiber between the interrogator unit and sensor head. Instead, inexpensive standard single mode fibers can be used. Using the integrated-optic waveguide beam splitter IOW also allows one to use standard fiber connectors (instead of expensive polarization-maintaining connectors) or, alternatively, to use standard fiber splicers. Another advantage of using the integrated-optic waveguide beam splitter IOW is that a design with a significantly longer distance (at least up to several kilometers) between the interrogator and the sensor head is feasible.

In an embodiment, the polarizing elements PE1 and PE2 may be implemented by a single polarizer because the polarizing element PE2 may be too narrow to be implemented and the polarizing elements PE1 and PE2 have the same polarization. FIG. 2 refers to a schematic diagram of a voltage sensing device 20 according to an embodiment of the present disclosure. The voltage sensing device 20 is similar to the voltage sensing device 10, thus components and signals with similar functions use the same symbols and are not described herein for brevity. In FIG. 2, the polarizing elements PE1 and PE2 are implemented by a polarizer and the polarizing element PE3 is implemented by another polarizer.

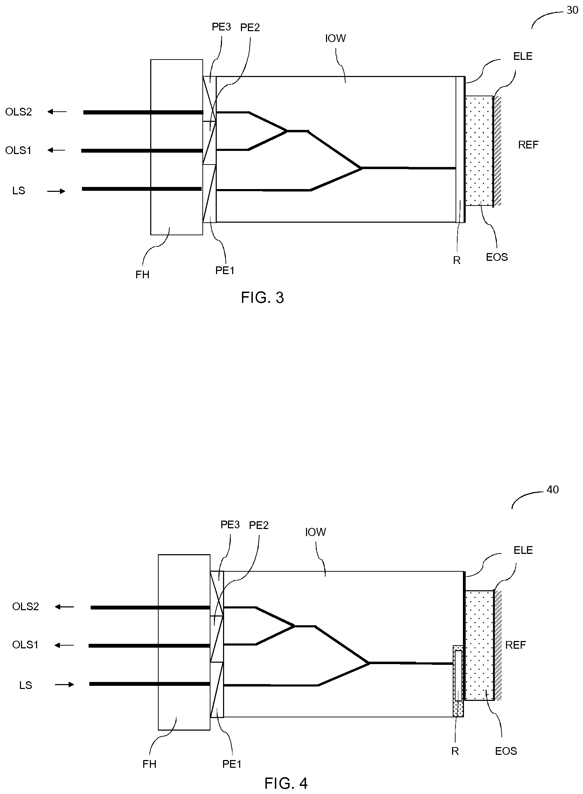

FIG. 3 refers to a schematic diagram of a voltage sensing device 30 according to an embodiment of the present disclosure. The voltage sensing device 30 is similar to the voltage sensing device 10, thus components and signals with similar functions use the same symbols and are not described herein for brevity. Different from the voltage sensing device 10, the voltage sensing device 30 adds electrodes ELE attached to sides across the electro-optic sensing element EOS, wherein one electrode ELE is configured between the birefringent optical element R and the electro-optic sensing element EOS and another one electrode is configured between the electro-optic sensing element EOS and the reflector REF. Preferably, the electrode ELE between the birefringent optical element R and the electro-optic sensing element EOS is deposited onto the birefringent optical element R. For easily contacting the birefringent optical element R, the electrode ELE between the birefringent optical element R and the electro-optic sensing element EOS laterally extends beyond the electro-optic sensing element EOS as shown in FIG. 3.

In this embodiment, at least one of the electrodes ELE is ohmically, i.e. electrically, coupled to an electric field generating electrode at a voltage V, typically with respect to ground.

In an embodiment, the electrodes ELE are formed by a conductive material which is transparent at an operation wavelength (e.g. the wavelength of the light signal LS). For example, the electrodes ELE may be formed of aluminum doped zinc oxide (AZO) which is transparent for light of wavelength 1310 nm. In another embodiment, the electrodes ELE may be non-transparent and have an aperture allowing light beam to pass. In still another example, the reflector REF may serve as the electrode ELE if consisting of conductive (e.g. metal) materials.

In an embodiment, the birefringent optical element R and/or the electro-optic sensing element EOS may be positioned in a recess of the integrated-optic waveguide beam splitter.

FIG. 4 refers to a schematic diagram of a voltage sensing device 40 according to an embodiment of the present invention. The voltage sensing device 40 is similar to the voltage sensing device 30, thus components and signals with similar functions use the same symbols and are not described herein for brevity. However, the retarder R is now a $\lambda/4$ retarder (instead of a $\lambda/8$ retarder) In FIG. 4, the birefringent optical element R is mounted in a recess of the integrated-optic waveguide beam splitter IOW with a soft gel in a stress-free manner. The electrode ELE between the birefringent optical element R and the electro-optic sensing element EOS is now an electrode layer on the integrated-optic waveguide beam splitter IOW and still extends beyond the electro-optic sensing element EOS.

In the embodiments shown in FIGS. 3 and 4, the voltage V is applied parallel to the path of the light signal LS (i.e. longitudinal Pockels effect occurs). As a matter of principle, the high voltage HV may be applied in a transverse direction to the propagation path of the light signal LS if the class and orientation of the electro-optic sensing element EOS are chosen accordingly.

In an embodiment, the birefringent optical element R and the electro-optic sensing element EOS may be integrally formed as a single element.

In this embodiment, a separate birefringent optical element R is omitted and its function is realized by natural birefringence of the electro-optic sensing element EOS. Under such a condition, a thickness of the electro-optic sensing element EOS needs to be appropriately chosen such that a (single pass) birefringent phase retardation of the electro-optic sensing element EOS becomes $(2n-1)\times\lambda/8$ or $(2n-1)\times45°$, where n is a positive integer (i.e. n = 1, 2, 3, ..., etc). Another requirement is that the electro-optic axes and principal axes of the natural birefringence of the electro-optic sensing element EOS coincide, a requirement met, e.g., by crystals of crystal class 3m, such as LiTaO3 or LiNbO3 or crystals of class 32 such as quartz. For example, if the electro-optic sensing element EOS consists of LiTaO3 (class 3m) whose ordinary and extraordinary refractive indices are 2.1327 and 2.1369 at 1310 nm, the thickness of the electro-optic sensing element EOS corresponding to the birefringent phase retardation of a zero-order (i.e. n = 1)$\lambda/8$-retarder is 39 $\mu$m. The corresponding thickness for an electro-optic sensing element EOS consisting of LiNbO3 is about 20 times smaller (about 2 $\mu$m) because LiNbO3 has larger birefringence. In the embodiments employing the longitudinal electro-optic effect in crystals of class 3m, the electro-optic sensing element EOS must be orientated with the y-axis parallel to the propagation direction of the light signal LS and the crystallographic z-axis must be oriented at 45° to the polarization direction. The relevant electro-optic coefficient is r12.

For crystal class 32 (an example is quartz) and again considering the longitudinal electro-optic effect, an x-direction must be aligned parallel to the propagation direction and the 3-fold axis (z-axis) must be at 45° to the polarization direction. The electro-optic effect is governed by the coefficient r11 in this configuration. The thickness of a quartz zero-order $\lambda/8$-retarder is 19.4 $\mu$m at 1310 nm. A quartz platelet with a thickness of about 290 $\mu$m would represent a $\lambda/8$-retarder of order m = 7.

In an embodiment, the polarizing element PE1 and the polarizing elements PE2 and PE3 may be configured at opposite sides of the integrated-optic waveguide beam splitter IOW and/or the electro-optic sensing element EOS and the polarizing element PE1 may be configured at the same side of the integrated-optic waveguide beam splitter IOW. In this embodiment, the voltage sensing device does not have the reflector REF.

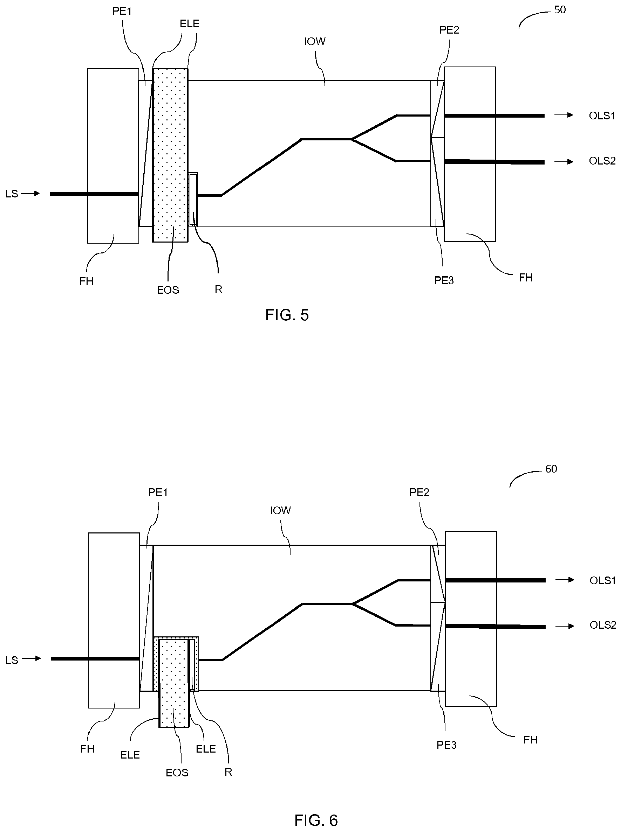

FIG. 5 refers to a schematic diagram of a voltage sensing device 50 according to an embodiment of the present invention. As shown in FIG. 5, the birefringent optical element R is configured in a recess of the integrated-optic waveguide beam splitter IOW, the electro-optic sensing element EOS is coupled to a side of the integrated-optic waveguide beam splitter IOW having the recess and the polarizing element PE1 is coupled to the electro-optic sensing element EOS. Note that, the electro-optic sensing element EOS comprises the electrodes ELE configured between the polarizing element PE1 and the electro-optic sensing element EOS and between the electro-optic sensing element EOS and the integrated-optic waveguide beam splitter IOW. In addition, the birefringent optical element R shown in FIG. 5 is a $\lambda/4$-wave retarder in order to provide $(2n-1)\times90°$ phase bias between the orthogonal polarization components in the light signal LS under the condition that the light signal LS passes the birefringent optical element R only once.

In the embodiment shown in FIG. 5, the orientations of the polarizing elements PE1, PE2, PE3, the electro-optic sensing element EOS and the birefringent optical element R are similar to those of the embodiment of FIG. 1. The light signal LS is input to the polarizing element PE1 via an optic fiber (e.g. a single mode optic fiber) fixed by the fiber holder FH. Note that the waveguide of the integrated-optic waveguide beam splitter IOW is positioned at a lower edge of the electro-optic sensing element EOS, so as to provide more gluing surface between the electro-optic sensing element EOS and the integrated-optic waveguide beam splitter IOW and to enhance a mechanical stability. Furthermore, this waveguide configuration offset also prevents unguided stray light from reentering the waveguide. After the light signal LS passes the polarizing element PE1, the electro-optic sensing element EOS and the birefringent optical element R, the integrated-optic waveguide beam splitter IOW splits the light signal LS and transmits the split light signals to the polarizing elements PE2 and PE3. The photo detectors and the processing unit (not shown in FIG. 5) therefore can determine the voltage V based on the output light signals OLS1 and OLS2 (i.e. the split light signals passing through the polarizing elements PE2 and PE3).

In an embodiment, both the birefringent optical element R and the electro-optic sensing element EOS are positioned in a recess of the integrated-optic waveguide beam splitter IOW.

FIG. 6 refers to a schematic diagram of a voltage sensing device 60 according to an embodiment of the present disclosure. In comparison with the voltage sensing device 50, the voltage sensing device 60 changes the position of the electro-optic sensing element EOS to an enlarged recess of the integrated-optic waveguide beam splitter IOW. In this embodiment, a risk of the phase bias being affected by temperature-dependent stresses can be further reduced.

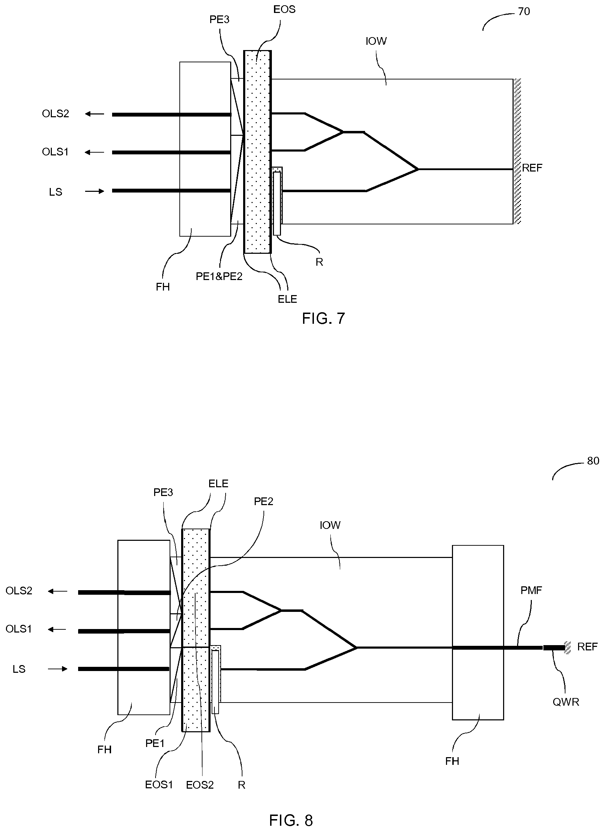

FIG. 7 refers to a schematic diagram of a voltage sensing device 70 according to an embodiment of the present disclosure. The voltage sensing device 70 comprises a fiber holder FH, polarizing elements PE1, PE2, PE3, an integrated-optic waveguide beam splitter IOW, a birefringent optical element R ($\lambda/4$ retarder), an electro-optic sensing element EOS and a reflector REF. In this embodiment, the birefringent optical element R and the electro-optic sensing element EOS are coupled to a side of the integrated-optic waveguide beam splitter IOW and the reflector REF is coupled to an opposite side of the integrated-optic waveguide beam splitter IOW. In addition, the polarizing elements PE1 and PE2 are implemented by one polarizer, the polarizing element PE3 is implemented by another polarizer and both polarizers are coupled to the electro-optic sensing element EOS.

In comparison with the orientations of the polarizing elements PE1, PE2, PE3, the birefringent optical element R and the electro-optic sensing element EOS of the embodiment shown in FIG. 1, the orientations of the polarizing elements PE1, PE2, PE3, the birefringent optical element R and the electro-optic sensing element EOS in the embodiment shown in FIG. 7 are rotated by 45°. In detail, the polarization direction of the polarizing elements PE1 and PE2 is 45° with respect to the normal of the splitter plane of the integrated-optic waveguide beam splitter IOW and the polarization direction of the polarizing element PE3 is -45° with respect to the normal of the splitter plane of the integrated-optic waveguide beam splitter IOW. Accordingly, a principal axis of the birefringent optical element R is and an electro-optic axis of the electro-optic sensing element are at 0° with respect to the normal of the splitter plane of the integrated-optic waveguide beam splitter IOW.

With the orientations of the polarizing elements PE1, PE2, PE3, the electro-optic sensing element EOS and the birefringent optical element R of this embodiment, any residual birefringence provided by the waveguides in the integrated-optic waveguide beam splitter IOW would introduce an extra and temperature-dependent phase bias for the orthogonal polarization modes in the light signal LS. Therefore, the waveguides of the integrated-optic waveguide beam splitter IOW is preferably of low birefringence in this embodiment. On the other hand, the birefringent optical element R may be omitted and its function can be realized by the waveguides in the integrated-optic waveguide beam splitter IOW. That is, the length of the waveguide is appropriately chosen such that the roundtrip phase retardation of the light signal LS generated when passing the waveguide is $(2k+1)\times\pi/4$, where k is an integer (i.e. k = 0, 1, 2, ..., etc).

FIG. 8 refers to a schematic diagram of a voltage sensing device 80 according to an embodiment of the present disclosure. The voltage sensing device 80 comprises a fiber holder FH, polarizing elements PE1, PE2, PE3, an integrated-optic waveguide beam splitter IOW, a birefringent optical element R ($\lambda/4$ retarder), electro-optic sensing elements EOS1 and EOS2, an optic fiber PMF, a fiber optic quarter-wave retarder QWR and a reflector REF. In this embodiment, the orientations of the polarizing elements PE1, PE2, PE3 and the electro-optic sensing element EOS1 are similar to those of the polarizing elements PE1, PE2, PE3 and the electro-optic sensing element EOS shown in FIG. 7. In addition, electro-optic axes of the electro-optic sensing element EOS2 are approximately orthogonal to the corresponding axes of the electro-optic sensing element EOS1.

In FIG. 8, the optic fiber PMF may be a polarization maintaining fiber and a principal axis is parallel to the normal of the splitter plane of the integrated-optic waveguide beam splitter IOW. The fiber optic quarter-wave retarder QWR is comprised of a short piece of the optic fiber PMF (e.g. an elliptical-core fiber of low temperature dependence) with a length corresponding to a quarter of the beat length and the reflector REF may be a reflective coating of the fiber optic quarter-wave retarder QWR. In this embodiment, the fiber optic quarter-wave retarder QWR swaps the two orthogonal polarization states of the light signal LS when the light signal LS makes a round trip through the PMF and the fiber optic quarter-wave retarder QWR. Under such a condition, the birefringence phase retardation generated by the waveguides in the integrated-optic waveguide beam splitter IOW can be canceled.

In an alternative embodiment, the fiber optic quarter-wave retarder QWR and the reflector REF shown in FIG. 8 may be replaced by a Faraday rotator mirror with a roundtrip rotation angle of 90°.

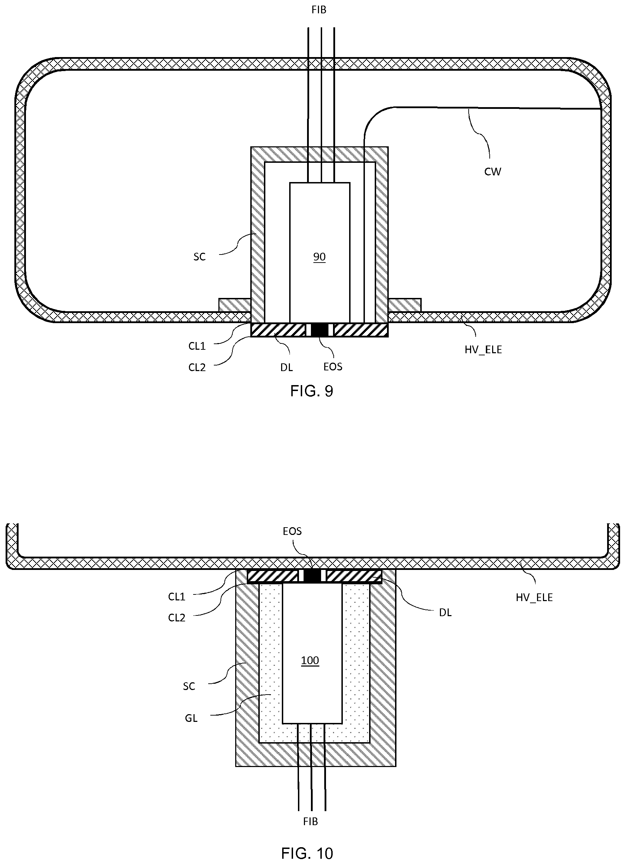

FIG. 9 refers to a schematic diagram of an arrangement of a voltage sensing device 90 according to an embodiment of the present disclosure. In FIG. 9, a voltage sensing device 90 is mounted on an electric field generating electrode V_ELE of the voltage V, wherein the voltage sensing device 90 can be one of the voltage sensing devices 10, 20, 30, 40, 70 and 80. In order to simplify the drawing, FIG. 9 only shows the electro-optic sensing element EOS of the voltage sensing device 90, and fibers FIB utilized for transmitting the light signal LS and the output signals OLS1 and OLS2. The components of the voltage sensing device 90 not related to illustrations of this embodiment are not shown for brevity.

In FIG. 9, a sensor casing SC covering the voltage sensing device 90 is mounted on the electric field generating electrode HV_ELE such that the electrode ELE of the electro-optic sensing element EOS that faces the integrated-optic waveguide beam splitter IOW is on level with an outer surface of the electric field generating electrode HV_ELE. The voltage sensing device 90 further comprises a dielectric layer DL in which the electro-optic sensing element EOS is configured. In addition, conductive layers CL1 and CL2 are added at opposite sides of the dielectric layer DL. In this embodiment, the conductive layer CL1 is coupled (e.g. ohmically/electrically coupled) to one of the electrodes ELE of the electro-optic sensing element EOS and the conductive layer CL2 is coupled (e.g. ohmically/electrically coupled) to another one of the electrodes ELE of the electro-optic sensing element EOS. In an embodiment, the conductive layers CL1 and CL2 may be metal electrodes. Under such a condition, the the electro-optic sensing element EOS and its electrodes form a capacitor and the dielectric layer DL and its conductive layers CL1 and CL2 form another capacitor parallel to the capacitor formed by the electro-optic sensing element EOS and its electrodes In FIG. 9, the conductive layer CL1 is ohmically coupled to the electric field generating electrode V_ELE via a contact wire CW to make sure that the conductive layer CL1 has the potential of the electric field generating electrode V_ELE and the conductive layer CL2 is on a floating potential. As a result, the voltage sensing device 90 is able to sense the voltage of the electric field generating electrode HV_ELE with respect to another electrode (not shown in FIG. 9) (which typically is at the ground potential).

In the embodiment of FIG. 9, the dielectric layer DL is utilized to enhance the sensitivity of the voltage sensing device 90. More specifically, the dielectric constant of the dielectric layer DL is smaller than that of the electro-optic sensing element EOS, so as to enhance the electric field inside the electro-optic sensing element EOS. The sensitivity of the voltage sensing device 90 is therefore enhanced. For example, the electro-optic sensing element EOS may consist of BGO whose dielectric constant is 16 and the dielectric layer DL may consist of fused silica whose dielectric constant is 3.7 or polymers such as polyetheretherketone (PEEK) whose dielectric constant is 3.2 and polytetrafluoroethylene (Teflon) whose dielectric constant is 2.1. Under the condition that the surface area of the dielectric layer DL and the conductive layers CL1 and CL2 is much larger than that of the electro-optic sensing element EOS and electrodes ELE, the electric field inside the electro-optic sensing element EOS is enhanced by approximately a ratio between the dielectric constants of the electro-optic sensing element EOS and the dielectric layer DL. For example, the electric field inside the electro-optic sensing element EOS is enhanced 5 times when the electro-optic sensing element EOS consists of the BGO and the dielectric layer DL consists of the fused silica.

FIG. 10 refers to a schematic diagram of an arrangement of a voltage sensing device 100 according to an embodiment of the present disclosure. In FIG. 10, a gel layer GL is added between the sensor casing SC and the voltage sensing device 100. Different from the voltage sensing device 90 mounted on the electric field generating electrode V_ELE at an inner side of the electric field generating electrode V_ELE, the voltage sensing device 100 is mounted on the electric field generating electrode V_ELE at an outer side of the electric field generating electrode V_ELE. The sensor casing SC consists of non-conducting materials, the conducting layer CL1 is ohmically coupled to the electric field generating electrode V_ELE (is on the potential of the electric field generating electrode V_ELE) and the conducting layer CL2 contacting the voltage sensing device 1000 is on a floating potential.

In an embodiment, the dielectric layer DL may be thicker than the electro-optic sensing element EOS to strengthen the effect of enhancing the electric filed inside of the electro-optic sensing element EOS.

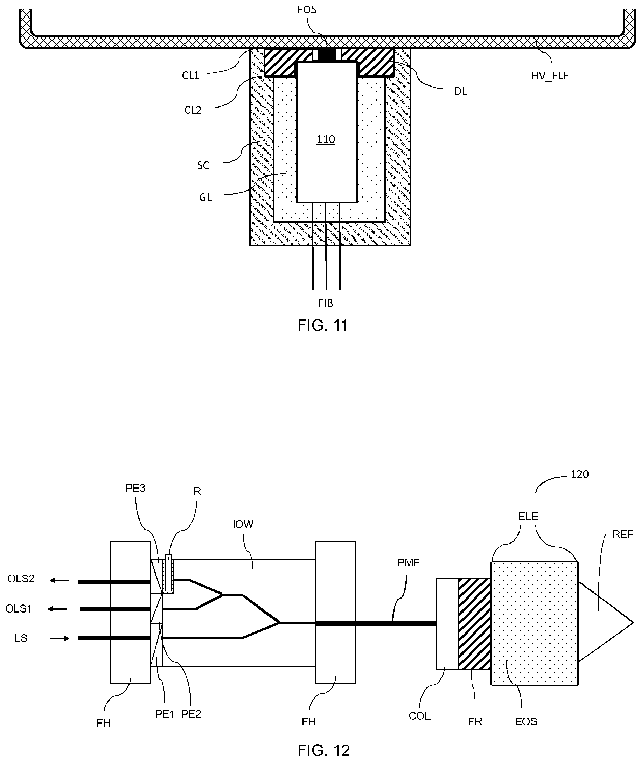

FIG. 11 refers to a schematic diagram of an arrangement of a voltage sensing device 110 according to an embodiment of the present disclosure. Different from the voltage sensing devices 90 and 100, the voltage sensing device 110 increases a thickness of the dielectric layer DL to be greater than that of the electro-optic sensing element EOS. As a result, the electric field inside the electro-optic sensing element EOS could be further enhanced.

FIG. 12 shows a voltage sensing device 120 according to an embodiment of the present disclosure. The voltage sensing device 120 comprises fiber holders FH, polarizing elements PE1, PE2, PE3, an integrated-optic waveguide beam splitter IOW, a birefringent optical element R ($\lambda$/4 retarder), an optic fiber PMF, a collimator COL (e.g. a graded index lens (GRIN)), a 45°-Faraday rotator FR, an electro-optic sensing element EOS and a reflector REF. In this embodiment, orientations of the polarizing elements PE1, PE2 and PE3, the birefringent optical element R, and the optic fiber PMF are similar to those of the polarizing elements PE1, PE2 and PE3, the birefringent optical element R, and the optic fiber PMF shown in FIG. 8 and are not described herein for brevity. By contrast, an electro-optic axis of the electro-optic sensing element EOS is at 45° with respect to the normal of the splitter plane. In FIG. 12, the birefringent optical element R changes to be configured on the light propagation path to the polarizing element PE3.

In FIG. 12, the light signal LS passes through the polarizing element PE1, the integrated-optic waveguide beam splitter IOW and the optic fiber PMF, is collimated by the collimator COL, passes the 45°-Faraday rotator FR and the electro-optic sensing element EOS and is reflected by the reflector REF (e.g. a reflecting prism). The electro-optic axes of the electro-optic sensing element EOS are at about $\pm$45° to the principal axis of the optic fiber PMF which is about 0° with respect to the normal of the integrated-optic waveguide beam splitter IOW. The electro-optic sensing element EOS again introduces a differential electro-optic phase shift between the orthogonal polarization components of the light signal (LS) parallel to the electro-optic axes in response to an electric field generated by a voltage V. The two orthogonal polarization states which were parallel to the principal axes of the optic fiber PMF are parallel to the electro-optic axes of the electro-optic sensing element EOS after the two orthogonal polarization states have passed the 45°-Faraday rotator FR and experienced a 45°-polarization-rotation. On the return trip the two orthogonal polarization states experience an additional 45°-polarization rotation because of the 45°-Faraday rotator FR (i.e., the total roundtrip rotation is then 90°), so that the birefringent phase retardations generated by the optic fiber PMF and the waveguides in the integrated-optic waveguide beam splitter IOW are canceled when the light signal LS goes through a full roundtrip and splits to the split light signals to the polarizing elements PE2 and PE3. Due to the birefringent optical element R being only in the light propagation path to the polarizing element PE3, the output light signals OLS1 and OLS2 are 90° out of phase (i.e. at quadrature). The electro-optic phase shift therefore can be unambiguously recovered even under the conditions that large phase shifts occur corresponding to multiples of $\pi$. Note that, the output light signals OLS1 and OLS2 become anti-phase (i.e. 180° out of phase) if the birefringent optical element R resides on the light propagation path of the light signal LS input from the polarizer of polarizing element PE1 or on both the propagation paths to the polarizing elements PE2 and PE3.

Also note that, the electro-optic sensing element EOS shown in FIG. 12 may be mounted on an electric-field generating electrodes according to the embodiments shown in FIGS. 9 to 11 via appropriate alternations.

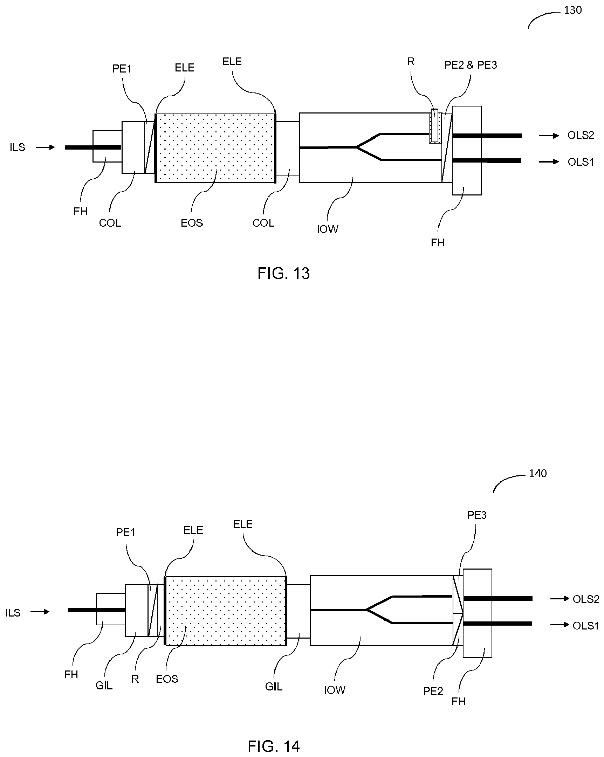

FIG. 13 relates to a voltage sensing device 130 according to an embodiment of the present disclosure, wherein the voltage sensing device 130 is another configuration of the voltage sensing device 120 shown in FIG. 12. In FIG. 13, the integrated-optic waveguide beam splitter IOW is a 1$\times$2 polarization splitter and is connected to an electro-optic sensing element EOS via a collimator COL (e.g. collimating graded index lens). In addition, the collimator COL is coupled between the electro-optical sensing element EOS and the integrated-optic waveguide beam splitter IOW and is configured to couple the light signal LS into the integrated-optic waveguide beam splitter IOW and another collimator COL is coupled to the first polarizing element (PE1) and configured to collimate the light signal LS before the light signal LS enters the first polarizing element PE1.

The orientations of the polarizing elements PE1, PE2 are at 45° to the normal of the splitter plane, a principal axis of the birefringent optical element R and an electro-optic axis of the electro-optic sensing element EOS are at 0°.Due to the orientations of the voltage sensing device 130, the waveguides in the integrated-optic waveguide beam splitter IOW must have low birefringence in order to avoid undefined phase offsets. In addition, the output light signals OLS1 and OLS2 are at quadrature (i.e. 90° out of phase).

FIG. 14 relates to a voltage sensing device 140 according to an embodiment of the present disclosure, wherein the voltage sensing device 140 is still another configuration of the voltage sensing device 120 shown in FIG. 12. In comparison with the voltage sensing device 130, the birefringent optical element R changes to be configured at an input side of the light signal LS. In addition, the orientations of the polarizing elements PE1, PE2, the electro-optic sensing element EOS and the birefringent optical element R are rotated by 45°. The polarization directions of the polarizing elements PE2 and PE3 are respectively at about 0° and 90° with respect to the normal of the splitter plane of the integrated-optic waveguide beam splitter IOW. By adopting the orientations shown in FIG. 14, the birefringence generated by the integrated-optic waveguide beam splitter IOW does not affect the phase offset of the output light signals OLS1 and OLS2. In this embodiment, the output light signals OLS1 and OLS2 are anti-phase (i.e. 180° out of phase).

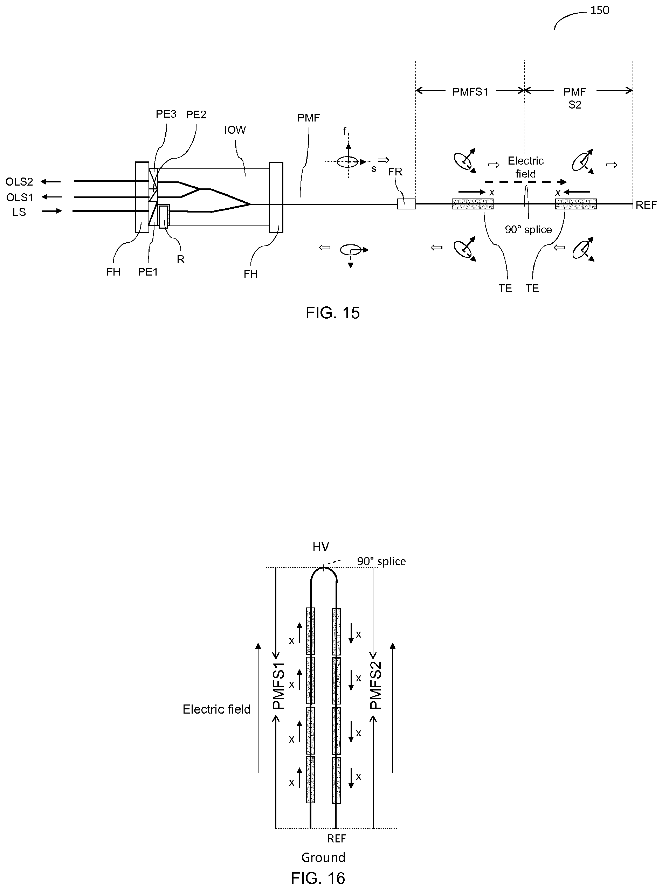

FIG. 15 relates to a voltage sensing device 150 according to an embodiment of the present disclosure. In comparison with the embodiment shown in FIG. 12, the voltage sensing device 150 replaces the electro-optic sensing element EOS with piezo-electric transducer elements TE. The light signal LS travels through a polarizing element PE1 (polarization direction at 45° to the normal of the splitter plane), a birefringent optical element R (a principal axes at 45°) and an optic fiber PMF (a polarization maintaining fiber, a principal axes at 45°) and to a Faraday rotator FR with a 45° rotation angle per pass, wherein orthogonal components in the light signal LS are indicated by solid and dashed arrows in FIG. 15. In other words, each component is rotated by 45° each time the light signal LS passes through the Faraday rotator FR. The rotation is non-reciprocal, i.e. the rotation as seen from an observer looking towards the light beam is, for example, clockwise if the beam propagates from left to right, but counter-clockwise if the beam propagates from right to left. The light signal LS exiting from the Faraday rotator FR is coupled into a sensing section PMFS1 which comprises the optic fiber PMF. The fast and slow axes of the sensing section PMFS1 are oriented at 45° with respect to the splitter plane of the integrated-optic waveguide beam splitter IOW. Thus, the polarization directions of the components of the light signal LS after the rotation again coincide with the birefringent axes of the sensing section PMFS1. Another sensing section PMFS2 comprising the optic fiber PMF is spliced to the sensing section PMFS1 with its axes rotated by 90° with respect to that of the sensing section PMFS1. That is, a slow axis of the sensing section PMFS1 of the optic fiber PMF is orthogonal to a slow axis of the sensing section PMFS2 of the optic fiber PMF. As shown in FIG. 13, the components polarized parallel to the slow axis in the sensing section PMFS1 are then polarized along the fast axis in the sensing section PMFS2 and vice versa. The length of PMFS1 and PMFS2 are chosen such that the orthogonal polarization modes experience the same modal group delays (absolute values) in the two fiber sections, i.e. the length are identical if the fiber parameters of the two sections are identical. The light signal LS is reflected at the end of sensing section PMFS2 by a reflector REF and backs to the integrated-optic waveguide IOW. The Faraday rotator FR introduces another 45° rotation angle to the light signal LS. The total rotation is thus 90° (or 90° + k×180°, where k is an integer). As a result, the birefringence phase retardation generated by the integrated-optic waveguide beam splitter IOW and the PMF can be canceled.

The piezo-electric elongation or contraction (i.e. strains) of the piezo-electric transducer elements TE in an electric field (e.g. generated by the voltage H) is transmitted to two sensing sections PMFS1 and PMFS2 of the optic fiber PMF. Note that for a given direction of the electric field, the piezo-electric strains of the piezo-electric transducer elements TE attached to the sensing section PMFS1 are opposite in sign to the piezo-electric strains of the piezo-electric transducer elements TE attached to the sensing section PMFS2 of polarization maintaining fiber PMF as a result of anti-parallel orientation of the crystallographic x-axis. The resulting fiber strain causes a differential phase shift between the orthogonal components in the light signal LS.

The crystallographic axes of the piezo-electric transducer elements TE are parallel to the longitudinal directions of the piezo-electric transducer elements TE and are anti-parallel as shown of an x-axis corresponding to each piezo-electric transducer elements TE in FIG. 15. In combination with the 90°-splice the differential phase shifts in the sensing sections PMFS1 and PMFS2 add up if the electric field direction is the same at both piezo-electric transducer elements TE, whereas phase shifts caused by common mechanical disturbances cancel out.

In an embodiment, the piezo-electric transducer elements TE are made by quartz. In an embodiment, the piezo-electric transducer elements TE may have the form of platelets with straight fiber segments bonded to the platelets as shown in FIG. 15. In another embodiment, the piezo-electric transducer elements TE may be cylinder-shape with the fiber wrapped onto the cylinder surface.

After returning to the integrated-optic waveguide beam splitter IOW, the light signal LS splits to the polarizing elements PE2 and PE3The output light signals OLS1 and OLS2 are anti-phase. Because having the different phase shifts corresponding to the electric field at the piezo-electric transducer elements TE, the output light signals OLS1 and OLS2 can be utilized to determine the strength of the electric field at the piezo-electric transducer elements TE and a corresponding voltage (e.g. a high voltage HV).

FIG. 16 relates to an arrangement of a plurality of piezo-electric transducer elements TE between ground potential and a high voltage (HV) potential. As shown in FIG. 16, the piezo-electric transducer elements TE of the sensing section PMFS1 are arranged anti-parallel to the corresponding piezo-electric transducer elements TE of the sensing sections PMFS2.

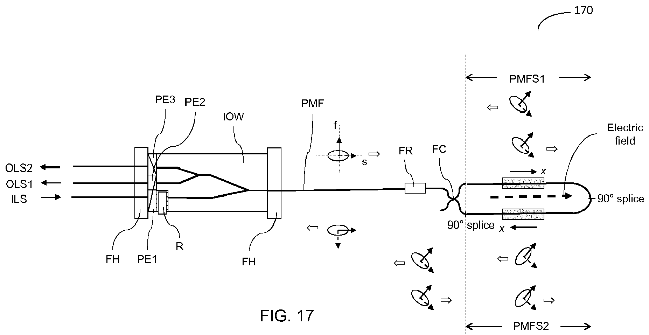

FIG. 17 relates to a voltage sensing device 170 according to an embodiment of the present disclosure. The voltage sensing device 170 is similar to the voltage sensing device 150 shown in FIG. 15, thus, the components and signals with similar functions use the same symbols and are not described herein for brevity. In FIG. 17, a fiber coupler FC (e.g. a polarization maintaining fiber coupler) and the two sensing sections PMFS1 and PMFS2 form a loop mirror. As shown in FIG. 17, the loop contains two 90°-splices and the splices divide the loop in two halves with identical lengths (i.e. the sensing sections PMFS1 and PMFS2). In this embodiment, the reflector is not needed. Based on FIG. 16, the differential phase shifts in the sensing sections PMFS1 and PMFS2 add up if the crystallographic x-directions and the electric field directions are as indicated in FIG. 17.

According to an embodiment of the present disclosure, the integrated-optic waveguide beam splitter IOW, which is a passive element, , can be part of sensor head assembly, in contrast to designs employing active devices such as modulators. IAs a result, there is no need of polarization maintaining specialty fiber between the interrogator unit and sensor head. Instead, inexpensive standard single mode fibers can be used. Using the integrated-optic waveguide beam splitter IOW also enables using standard fiber connectors (instead of expensive polarization-maintaining connectors) or, alternatively, using standard fiber splicers. Furthermore, the design enables long distances (at least up to several kilometers) between the interrogator and the sensor.

**Claims**

1. A voltage sensing device, in particular an integrated voltage sensing device, comprising:

   an integrated-optic waveguide beam splitter (IOW), having a splitter plane,
   a first polarizing element (PE1), coupled to the integrated-optic waveguide beam splitter (IOW) and having a first polarization direction with respect to a normal of the splitter plane;
   a second polarizing element (PE2), coupled to the integrated-optic waveguide beam splitter (IOW) and having the first polarization direction with respect to the normal of the splitter plane;
   a third polarizing element (PE3), coupled to the integrated-optic waveguide beam splitter (IOW) and having a second polarization direction orthogonal to the first polarization direction;
   a birefringent optical element (R), having a principal axis at 45° ($\pm$15°) to the first polarization direction; and
   at least one electro-optic sensing element (EOS), having an electro-optic axis at 45° ($\pm$15°) to the first polarization direction,
   wherein the voltage sensing device is configured to let a light signal (LS) pass the first polarizing element (PE1), the birefringent sensing element (R), and the at least one electro-optic sensing element (EOS),
   wherein the birefringent optical element (R) is configured to introduce a phase bias in a range of (2n -1) $\times$ 45° ($\pm$15°) or (2n -1) $\times$ 90° ($\pm$15°) between two orthogonal polarization components of the light signal (LS), where n is a positive integer,
   wherein the at least one electro-optic sensing element (EOS) is configured to introduce a differential electro-optic phase shift between two orthogonal polarization components of the light signal (LS) in response to an electric field generated by a voltage, and
   wherein the integrated-optic waveguide beam splitter (IOW) is configured to split the light signal (LS) into a first split light signal and a second split light signal, to transmit the first split light signal to the second polarizing element (PE2) and to transmit the second split light signal to the third polarizing element (PE3).

2. The voltage sensing device of claim 1, wherein the electro-optic sensing element (EOS) is in contact with the integrated-optic waveguide beam splitter (IOW), preferably via a layer of adhesive or an air gap.

3. The voltage sensing device of claim 1 or 2, wherein the birefringent optical element (R) and the at least one electro-optic sensing element (EOS) are integrally formed as a single element.

4. The voltage sensing device of any of claims 1 to 3, wherein the first polarization direction is 0° with respect to the normal of the splitter plane, or wherein the first polarization direction is 45° with respect to the normal of the splitter plane.

5. The voltage sensing device of any of claims 1 to 4, further comprising:

   a first electrode configured at a first side of the at least one electro-optic sensing element (EOS); and
   a second electrode configured at a second side of the at least one electro-optic sensing element (EOS) opposite to the first side of the at least one electro-optic sensing element (EOS),
   wherein at least one of the first electrode and second electrode is ohmically coupled to an electric field generating electrode.

6. The voltage sensing device of claim 5, further comprising:

   a dielectric layer (DL), wherein the at least one electro-optic sensing element (EOS) is configured in the dielectric layer (DL);
   a first conductive layer (CL1), coupled to the dielectric layer (DL) at a first side of the dielectric layer (DL) and ohmically coupled to the first electrode; and
   a second conductive layer (CL2), coupled to the dielectric layer (DL) at a second side of the dielectric layer (DL) opposite to the first side of the dielectric layer (DL) and ohmically coupled to the second electrode,
   optionally wherein a dielectric constant of the dielectric layer (DL) is smaller than a dielectric constant of the at least one electro-optic sensing element (EOS), and/or
   optionally wherein a surface area covered by the first conductive layer (CL1) and the second conductive layer (CL2) is greater than a surface area covered by the first electrode and the second electrode.

7. The voltage sensing device of claim 6, wherein a thickness of the dielectric layer (DL) is equal to or greater than a thickness of the at least one electro-optic sensing element (EOS).

8. The voltage sensing device of any of claims 1 to 7, wherein the at least one electro-optic sensing element (EOS) comprises at least one electro-optic crystal, the least one electro-optic crystal preferably consisting of one of Bi4Ge3012 (BGO), Bi4Si3O12 (BSO), crystalline quartz, LiTaO3, and $LiNbO_3$.

9. The voltage sensing device of any of claims 1 to 8, wherein the at least one electro-optic sensing element (EOS) comprises:

   a first electro-optic sensing element, configured to introduce a differential electro-optic phase shift between two orthogonal polarization components of the light signal (LS) in response to the electric field generated by the voltage; and
   a second electro-optic sensing element, configured to introduce a differential electro-optic phase shift between two orthogonal polarization components of the first split light signal and the second split light signal in response to the electric field generated by the voltage.

10. The voltage sensing device of any of claims 1 to 9, wherein the birefringent optical element (R) is provided in a recess of the integrated-optic waveguide beam splitter (IOW).

11. The voltage sensing device of any of claims 1 to 10, wherein the at least one electro-optic sensing element (EOS) is configured in a recess of the integrated-optic waveguide beam splitter (IOW).

12. The voltage sensing device of any of claims 1 to 11, wherein the first polarizing element (PE1), the second polarizing element (PE2) and the third polarizing element (PE3) are coupled to a first side of the integrated-optic waveguide beam splitter (IOW) and the voltage sensing device further comprises:

   a reflector configured to make the light signal (LS) return to the integrated-optic waveguide beam splitter (IOW), optionally wherein the first polarizing element (PE1) and the second polarizing element (PE2) are implemented by a first polarizer and the third polarizing element (PE3) is implemented by a second polarizer.

13. The voltage sensing device of claim 12, wherein the birefringent optical element (R), the at least one electric-optical sensing element (EOS) and the reflector are coupled to a second side of the integrated-optic waveguide beam splitter (IOW) opposite to the first side of the integrated-optic waveguide beam splitter (IOW).

14. The voltage sensing device of claim 12 or 13, wherein the birefringent optical element (R) and the at least one electro-optic sensing element (EOS) are coupled to the first side of the integrated-optic waveguide beam splitter (IOW),
   wherein the first polarizing element (PE1), the second polarizing element (PE2) and the third polarizing element (PE3) are coupled to the at least one electro-optic sensing element (EOS), and
   wherein the reflector is coupled to a second side opposite to the first side of the integrated-optic waveguide beam splitter (IOW).

15. The voltage sensing device of any of claims 1 to 14, wherein the at least one electro-optic sensing element (EOS) is ohmically coupled to an external electrode and introduces the differential electro-optic phase shift in response to a voltage of the external electrode with respect other electrodes.

FIG. 1

FIG. 2

FIG. 3

FIG. 4

EP 3 772 654 A1

FIG. 5

FIG. 6

20

FIG. 7

FIG. 8

FIB

CW

SC

90

CL1
CL2

DL    EOS

HV_ELE

FIG. 9

EOS

CL1
CL2

DL

HV_ELE

SC

GL

100

FIB

FIG. 10

EOS

CL1

CL2

SC

GL

110

DL

HV_ELE

FIB

FIG. 11

PE3    R    IOW    120

OLS2    ELE    REF

OLS1    PMF

LS

FH    PE1 PE2    FH    COL    FR    EOS

FIG. 12

130

PE1    ELE    ELE                    R    PE2 & PE3

ILS →

                                                      → OLS2
                                                      → OLS1

FH         EOS        COL
   COL                    IOW
                              FH

FIG. 13

140

PE1    ELE    ELE                         PE3

ILS →

                                                      → OLS2
                                                      → OLS1

FH   GIL  R  EOS      GIL      IOW    PE2
                                        FH

FIG. 14

FIG. 15

FIG. 16

FIG. 17

Europäisches
Patentamt

European
Patent Office

Office européen
des brevets

# EUROPEAN SEARCH REPORT

Application Number

EP 19 19 0749

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 6 122 415 A (BLAKE JAMES N [US]) 19 September 2000 (2000-09-19) * the whole document * ----- | 1-15 | INV. G01R15/24 |

TECHNICAL FIELDS
SEARCHED      (IPC)

G01R

The present search report has been drawn up for all claims

| Place of search | Date of completion of the search | Examiner |
|---|---|---|
| Munich | 15 November 2019 | Dogueri, Ali Kerem |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 19 19 0749

This annex lists the patent family members relating to the patent documents cited in the above-mentioned European search report.
The members are as contained in the European Patent Office EDP file on
The European Patent Office is in no way liable for these particulars which are merely given for the purpose of information.

15-11-2019

| Patent document cited in search report | | Publication date | Patent family member(s) | | Publication date |
|---|---|---|---|---|---|
| US 6122415 | A | 19-09-2000 | US | 6122415 A | 19-09-2000 |
| | | | WO | 0019217 A1 | 06-04-2000 |

EPO FORM P0459

For more details about this annex : see Official Journal of the European Patent Office, No. 12/82